(19) Europäisches Patentamt / European Patent Office / Office européen des brevets

(11) **EP 2 976 577 B1**

(12) **FASCICULE DE BREVET EUROPEEN**

(45) Date de publication et mention de la délivrance du brevet:
**13.12.2017 Bulletin 2017/50**

(21) Numéro de dépôt: **14719519.2**

(22) Date de dépôt: **13.03.2014**

(51) Int Cl.:
*F24J 2/48* $^{(2006.01)}$  *C23C 14/08* $^{(2006.01)}$
*C23C 28/04* $^{(2006.01)}$  *C23C 28/00* $^{(2006.01)}$
*C23C 14/06* $^{(2006.01)}$  *F24J 2/46* $^{(2006.01)}$
*G02B 5/08* $^{(2006.01)}$  *G02B 5/20* $^{(2006.01)}$
*G02F 1/01* $^{(2006.01)}$  *G02F 1/15* $^{(2006.01)}$
*G02B 1/11* $^{(2015.01)}$

(86) Numéro de dépôt international:
**PCT/FR2014/050590**

(87) Numéro de publication internationale:
**WO 2014/140499 (18.09.2014 Gazette 2014/38)**

(54) **MATÉRIAU ABSORBANT ET PANNEAU SOLAIRE UTILISANT UN TEL MATÉRIAU**

ABSORBIERENDES MATERIAL UND SOLARPANEEL MIT EINEM DERARTIGEN MATERIAL

ABSORBENT MATERIAL AND SOLAR PANEL USING SUCH A MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.03.2013 FR 1352344**

(43) Date de publication de la demande:
**27.01.2016 Bulletin 2016/04**

(73) Titulaires:
• **Viessmann Faulquemont**
  **57380 Faulquemont (FR)**
• **Centre National de la Recherche Scientifique (C.N.R.S.)**
  **75794 Paris (FR)**
• **Université de Lorraine**
  **54052 Nancy Cedex (FR)**

(72) Inventeurs:
• **MERCS, David**
  **F-57380 Faulquemont (FR)**
• **CAPON, Fabien**
  **F-54740 Germonville (FR)**
• **CORVISIER, Alan**
  **F-54510 Tomblaine (FR)**

(74) Mandataire: **Rhein, Alain**
  **Cabinet Bleger-Rhein-Poupon**
  **4A, rue de l'Industrie**
  **67450 Mundolsheim (FR)**

(56) Documents cités:
**WO-A1-2012/069718     US-A1- 2009 253 369**
**US-B2- 7 691 435**

• **GUINNETON F ET AL: "Optimized infrared switching properties in thermochromic vanadium dioxide thin films: role of deposition process and microstructure", THIN SOLID FILMS, ELSEVIER-SEQUOIA S.A. LAUSANNE, CH, vol. 446, no. 2, 15 janvier 2004 (2004-01-15), pages 287-295, XP004482225, ISSN: 0040-6090, DOI: 10.1016/J.TSF.2003.09.062 cité dans la demande**

EP 2 976 577 B1

**Description**

**Définitions**

Tout corps à la température T soumis à un rayonnement électromagnétique de longueur d'onde $\lambda$ et d'énergie incidente $E(\lambda, T)$ en transmet, absorbe ou réfléchit une partie selon la relation (1) suivante :

$$E(\lambda, T) = Et(\lambda, T) + Ea(\lambda, T) + Er(\lambda, T) = \tau. E(\lambda, T) + \alpha. E(\lambda, T) + \rho. E(\lambda, T) \tag{1}$$

où $\tau$, $\alpha$, $\rho$ sont respectivement les coefficients de transmission, d'absorption, et de réflexion du matériau. Ces coefficients sont également appelés transmittance, absorbance, et réflectance. Le principe de conservation de l'énergie totale incidente permet de relier ces coefficients entre eux selon la relation : $\tau + \alpha + \rho = 1$. Dans le cas où le corps considéré est opaque au rayonnement incident ($\tau=0$) son absorbance est complémentaire à sa réflectance ($\alpha=1-\rho$).

L'émissivité d'un matériau traduit sa capacité à émettre un rayonnement par rapport à un corps noir, qui absorbe toute l'énergie qu'il reçoit et qui rayonne toute l'énergie qu'il absorbe pour conserver son équilibre thermique (émissivité $\varepsilon = 1$), placé dans les mêmes conditions de température et de longueur d'onde. La loi de Kirchhoff précise qu'à l'équilibre thermique (température constante) et pour une longueur d'onde donnée, l'émissivité ($\varepsilon$) est égale à l'absorbance. Ainsi, pour une longueur d'onde donnée, l'émissivité peut être définie de la façon suivante : $\varepsilon = 1-\tau-\rho$ et dans le cas d'un corps opaque : $\varepsilon = 1-\rho$.

La réfraction est un phénomène de déviation d'une onde électromagnétique lorsque sa vitesse de propagation change entre deux milieux, et intervient généralement à l'interface entre ces deux milieux. Dans le cas général de matériaux absorbants ou métalliques, l'indice de réfraction est défini par un nombre complexe afin de rendre compte de l'atténuation des ondes dans le milieu. L'indice de réfraction est alors noté $N = n + i.k$, avec $n$ et $k$ étant l'indice optique et le coefficient d'extinction ou d'atténuation, respectivement. L'indice optique $n$ est défini comme le rapport entre la vitesse de la lumière dans le vide et la vitesse de propagation de l'onde considéré dans le milieu. Dans le cas d'un milieu non absorbant $k = 0$ (pas d'interaction entre l'onde et le milieu), l'indice de réfraction est égal à l'indice optique $n$. Le coefficient de réflexion d'un rayonnement électromagnétique à l'interface entre deux milieux dépend de l'indice de réfraction de ces deux milieux. D'une manière simplifiée, pour une incidence normale, la réflectance à l'interface entre deux milieux 1 et 2, le rayonnement allant de 1 vers 2, peut être exprimée de la manière suivante :

•

$$\rho_{1-2} = [(n_2-n_1)^2 + (k_2-k_1)^2] / [(n_2 + n_1)^2+(k_2 + k_1)^2] \tag{2}$$

**Domaine technique et état de l'art**

L'invention concerne un nouveau matériau absorbant, présentant des caractéristiques de réflectance infrarouge spécifiques. L'invention trouve notamment une application pour la fabrication de panneaux solaires, et en particulier les panneaux solaires thermiques.

La demande de brevet WO2012069718 décrit bien la problématique des matériaux absorbants pour les panneaux solaires, qui est résumée ici.

Pour réaliser un panneau solaire thermique efficace, on recherche un matériau ayant une absorption maximale (>90%) dans le visible et le proche infrarouge (longueurs d'onde $0,4 < \lambda < 2,5\mu m$) et une émissivité infrarouge minimale (<10%) pour des longueurs d'onde $\lambda$ typiquement comprises entre 6 et $10\mu m$, afin d'absorber au maximum l'énergie solaire tout en limitant au maximum les pertes d'énergie par rayonnement thermique lorsque le panneau est chaud. Lorsque le panneau solaire thermique est en fonctionnement normal, l'énergie solaire est convertie en chaleur qui est évacuée via un fluide caloporteur pour chauffer l'eau d'un réservoir, par exemple, à l'aide d'un échangeur thermique. Tant que le fluide caloporteur circule dans le panneau, au voisinage de l'absorbeur solaire, la chaleur du panneau est évacuée et sa température reste en dessous de 100-120°C.

Par contre, lorsque la circulation du fluide caloporteur est arrêtée, lorsque l'eau du réservoir a atteint une température souhaitée par exemple, le fluide caloporteur est immobile et n'évacue plus l'énergie emmagasinée par le panneau alors qu'il est toujours soumis au rayonnement solaire; la température du panneau augmente dans ce cas jusqu'à une température d'équilibre dite température de stagnation qui peut atteindre 220 à 250°C pour un ensoleillement de $1000W/m^2$. Une température de stagnation aussi élevée entraîne une dégradation rapide du fluide caloporteur qui doit être renouvelé souvent ; une telle température de stagnation impose également l'utilisation de matériau de construction de haute performance pour la réalisation du panneau, ainsi que la mise en place de système hydraulique pour gérer les surpressions (vase d'expansion).

Pour réduire la température de stagnation dans le panneau, le document WO2012069718 propose notamment :

- l'utilisation d'une couche d'un matériau à morphologie de surface variable en fonction de la température pour limiter l'absorbance du matériau pour des températures supérieures à une température seuil, ou bien
- la combinaison d'une couche d'un matériau à morphologie de surface variable et d'une couche absorbante en matériau thermochrome dont la transmittance Tr dans l'infrarouge (longueurs d'onde supérieures à 3 $\mu$m) est :

> ➢ supérieure à un premier seuil Tr1 de transmission lorsque la température T du matériau thermochrome est inférieure à une température critique Tc, et
> ➢ inférieure à un deuxième seuil Tr2 de transmission lorsque la température T° du matériau thermochrome est supérieure à la température critique Tc, le deuxième seuil de transmission étant inférieur au premier seuil de transmission.

A titre d'exemple, le document WO2012069718 propose la réalisation d'une couche absorbante en oxyde de Vanadium $VO_2$ ayant une absorbance assez importante dans le visible et le proche infrarouge (0,3 à 1,8 $\mu$m), de l'ordre de 70 à 80%, et présentant une transmittance infrarouge Tr variable, de manière réversible, en fonction de la température :

- à basse température (T < Tc), la transmittance Tr est de l'ordre de 90 à 100%
- à haute température (T > Tc), la transmittance Tr diminue fortement pour atteindre 5 à 15%.

Avec une transmittance inférieure à 15%, la couche absorbante est ainsi quasi opaque aux rayonnements infrarouges à T > Tc, et son émissivité est de l'ordre de 30 à 40%, ce qui entraîne une température de stagnation inférieure à celle qu'aurait un matériau ne comprenant pas la couche thermochrome.

En pratique, la réalisation de panneaux avec une couche à morphologie de surface variable est plutôt complexe à l'échelle industrielle. Et l'expérience montre que l'utilisation d'une couche de $VO_2$ seule, sans couche de matériau à morphologie de surface variable, permet certes de réduire la température de stagnation du matériau, mais pas suffisamment pour limiter les dégradations d'un fluide caloporteur circulant au voisinage du panneau ou pour permettre l'utilisation de matériaux moins chers pour réaliser le support et le cadre du panneau.

**Description de l'invention**

L'invention propose un nouveau matériau multicouche présentant une température de stagnation faible, et un panneau solaire comprenant un tel matériau multicouche. Plus précisément l'invention propose un nouveau matériau multicouche comprenant au moins:

un support ayant une réflectance R supérieure à 80% pour des rayonnements de longueur d'onde supérieure à 5$\mu$m, une couche sélective comprenant une combinaison d'oxydes de Vanadium $VO_2$ et $V_nO_{2n+/-1}$, avec n > 1, la dite couche sélective présentant une absorbance solaire supérieure à 75% pour des rayonnements de longueur d'onde comprise entre 0,4 et 2,5$\mu$m quelle que soit la température T et ayant, pour des rayonnements de longueur d'onde comprise entre 6 et 10 $\mu$m, une transmittance Tr telle que :

> ➢ Tr > 85 % pour T < Tc, une température critique,
> ➢ 20% =< Tr =< 50% pour T > Tc.

Des essais montrent qu'une couche de $VO_2$ pur présente à T > Tc une transmittance infrarouge (6-10$\mu$m) inférieure à 10% et est donc quasiment opaque. Pour T > Tc, pour des rayonnements infrarouges (6 - 10$\mu$m), la couche sélective selon l'invention se distingue par une transmittance infrarouge Tr partielle, comprise entre 20 et 50%, et est donc partiellement transparente.

La transmittance infrarouge (6-10$\mu$m) partielle de la couche sélective selon l'invention, à T > Tc se traduit par un coefficient d'extinction k2 dans l'infrarouge significativement plus faible qu'un coefficient d'extinction k2' d'une couche de $VO_2$ pur de même épaisseur et placée dans les mêmes conditions. De préférence, la couche sélective selon l'invention a un coefficient d'extinction k2 < 4.

1) Comportement à T > Tc de la couche sélective selon l'invention par rapport à une couche de $VO_2$ <u>pur</u>

L'expérience montre qu'une couche de $VO_2$ pur, correctement cristallisée et suffisamment épaisse pour présenter une absorbance supérieure à 75% pour des rayonnements de longueur d'onde comprise entre 0,3 et 2,5$\mu$m, ne peut pas présenter une transmittance infrarouge Tr supérieure à 10% à T > Tc, compte tenu d'un coefficient d'extinction k2' élevé, de l'ordre de 7. Une couche de $VO_2$ pur épaisse est donc opaque aux rayonnements infrarouges ($\lambda$ entre 6 et 10$\mu$m pour T > Tc.

Au contraire, dans le cadre de l'invention, l'expérience montre qu'en utilisant pour la couche sélective un matériau partiellement transparent à l'infrarouge (transmittance infrarouge Tr comprise entre 20% et 50% avec un coefficient d'extinction k2 faible) pour T > Tc, on obtient un matériau multicouche ayant une réflectance infrarouge plus faible (et donc une émissivité plus importante) pour les longueurs d'ondes dans le domaine de l'infrarouge (6-10 $\mu$m) que la réflectance infrarouge d'un autre matériau multicouche comprenant une couche sélective de $VO_2$ pur, avec pour conséquence une température de stagnation moindre que la température de stagnation d'un autre matériau multicouche comprenant une couche sélective de $VO_2$ pur.

A T > Tc, l'expérience montre également, grâce à des mesures de transmission et de réflexion par spectrométrie infrarouge par transformée de Fourrier (FTIR) de la couche sélective selon l'invention déposée sur un substrat en silicium, que l'augmentation de la transmittance infrarouge de la couche sélective selon l'invention est compensée par une diminution équivalente de la valeur de sa réflectance infrarouge ($\Delta$Tr = - $\Delta$R). La couche sélective selon l'invention réfléchit donc moins les infrarouges qu'une couche de $VO_2$ pur placée dans les mêmes conditions, tout en conservant une absorption infrarouge à 8$\mu$m équivalente, afin que la relation (1) soit toujours vérifiée ($\tau + \alpha + \rho = 1$). A titre d'exemple, le **tableau I** ci-dessous compare une couche de $VO_2$ pur et une couche $VO_2/V_4O_9$ de même épaisseur de 200nm ; on y constate immédiatement que $\Delta$Tr = Tr - Tr' = 0,2 = -(R - R') = -$\Delta$R.

*Tableau I : comparaison des valeurs expérimentale de l'absorbance, de la transmittance et de la réflectance d'une couche de $VO_2$ pur et d'une couche sélective selon l'invention, de même épaisseur (200nm), et pour un rayonnement de longueur d'onde 8$\mu$m.*

| $\lambda$ **= 8$\mu$m** | Couche de $VO_2$ pur à T>Tc | Couche sélective selon l'invention ($VO_2/V_4O_9$) à T > Tc |
|---|---|---|
| Transmittance (Tr) | Tr' = 0,10 | Tr = 0,30 |
| Réflectance (R) | R' = 0,55 | R = 0,35 |
| Absorbance (A) | A' = 1 - Tr' - R' = 0,35 | A = 1 - Tr - R = 0,35 |

Ainsi, à T > Tc, un rayonnement infrarouge de longueur d'onde comprise entre 6 et 10$\mu$m incident au matériau multicouche selon l'invention est donc :

1. moins réfléchi qu'une couche de $VO_2$ pur de même épaisseur (200nm dans l'exemple cité ci-dessus),
2. partiellement absorbé par la couche sélective avec une absorbance équivalente à celle d'une couche de $VO_2$ pur de même épaisseur,
3. partiellement transmis (20 à 50%) par la couche sélective jusqu'à l'interface entre la couche sélective et le support,
4. réfléchi quasiment intégralement (>80%) par le support bon réflecteur des infrarouges,
5. et partiellement retransmis, et donc réabsorbé partiellement, par la couche sélective selon l'invention avant de continuer sa progression vers l'extérieur du matériau multicouche.

Dans ces conditions, et compte tenu de l'absorbance constante de la couche sélective selon l'invention, l'augmentation du trajet du rayonnement infrarouge dans la couche sélective permet d'augmenter la fraction absorbée du rayonnement infrarouge incident par rapport à une couche de $VO_2$ pur de même épaisseur. A T > Tc l'émissivité infrarouge du matériau multicouche selon l'invention, à la longueur d'onde du rayonnement infrarouge incident, est donc plus importante qu'un matériau multicouche avec une couche sélective de $VO_2$ pur. Un panneau solaire thermique équipé d'un matériau multicouche selon l'invention présente donc une température maximale de fonctionnement (stagnation) inférieure à celle d'un panneau solaire thermique dont la couche sélective est constituée de $VO_2$ pur uniquement.

Dans un matériau multicouche selon l'invention, pour des rayonnements de longueur d'onde comprise entre 6 et 10 $\mu$m, si le support a un indice optique n1, la couche sélective a de préférence un indice optique n2 tel que :

n2 < n1 quelle que soit la température T, et
n2 < 6 pour T > Tc.

Ainsi, la réflectance infrarouge à T > Tc est encore réduite, notamment pour des longueurs d'onde voisines de 7 à 8 $\mu$m. Les meilleurs résultats sont obtenus avec un indice optique n2 compris entre $0,8*(n1)^{1/2}$ et $1,2*(n1)^{1/2}$ pour T > Tc. Avec de tels indices optiques n1, n2, et notamment avec un indice n2 proche de la racine carrée de n1, l'expérience montre que le rayonnement infrarouge partiellement transmis par la couche sélective est réfléchi par le support bon réflecteur des infrarouges (R > 80%) de telle manière qu'il crée un phénomène d'interférence destructive avec le rayonnement réfléchi à la surface de la couche sélective et ceci crée un effet antireflet à la surface de la couche sélective et réduit ainsi d'avantage la réflectance de la couche sélective pour une longueur d'onde donnée, et en particulier pour une longueur d'onde voisine de 7 à 8$\mu$m.

De préférence, le support présente un indice optique n1 élevé afin d'autoriser une plus grande latitude sur le choix de la valeur de l'indice optique n2 de la couche sélective. Par exemple, si le support bon réflecteur des infrarouges est en aluminium pur (réflectance R infrarouge > 95%), n1 est voisin de 16 dans l'infrarouge et la couche sélective selon l'invention doit présenter un indice optique n2 inférieur à 16 et aussi proche que possible de 4 pour maximiser l'effet antireflet dans l'infrarouge à l'interface entre la couche sélective et le support.

2) Comportement à **T < Tc** de la couche sélective selon l'invention par rapport à une couche de VO$_2$ <u>pur</u>

Comme cela est décrit ci-dessus, un matériau multicouche selon l'invention comprend au moins: un support ayant une réflectance R supérieure à 80% pour des rayonnements de longueur d'onde supérieure à 5$\mu$m, une couche sélective comprenant une combinaison d'oxydes de Vanadium VO$_2$ et $V_nO_{2n+/-1}$, avec n > 1, la dite couche sélective présentant une absorbance solaire supérieure à 75% pour des rayonnements de longueur d'onde comprise entre 0,4 et 2,5$\mu$m quelle que soit la température T et ayant, pour des rayonnements de longueur d'onde comprise entre 6 et 10 $\mu$m, une transmittance Tr telle que :

> ➢ Tr > 85 % pour T < Tc, une température critique,
> ➢ 20% =< Tr =< 50% pour T > Tc.

Ainsi, pour T < Tc, avec une absorbance solaire supérieure à 75% pour des rayonnements de longueur d'onde comprise entre 0,4 et 2,5$\mu$m, la couche sélective selon l'invention absorbe un maximum d'énergie solaire.

Egalement, avec une couche sélective dont la transmittance infrarouge Tr est supérieure à 85%, la réflectance infrarouge du matériau multicouche selon l'invention dépend essentiellement de la réflectance infrarouge élevée du support. Ceci se traduit par des pertes par rayonnement thermique limitée. Un tel matériau multicouche permet ainsi de réaliser un capteur solaire ayant un bon rendement, au moins tant que la température critique Tc n'est pas atteinte.

A T < Tc, avec Tr > 85%, la couche sélective est très transparente aux rayonnements infrarouges, ce qui se traduit par un coefficient d'extinction k2 proche de 0.

De préférence, à T < Tc, la couche sélective selon l'invention présente un indice optique n2 inférieur à 2,5 pour des longueurs d'onde voisines de 8$\mu$m. D'après le document US7,691,435 B2, et l'article de F. Guinneton et al. / Thin Solid Films 446 (2004) 287-295, une couche de VO$_2$ pur à basse température est caractérisée par un indice optique compris entre 2,5 et 3 pour des rayonnements dont la longueur d'onde est voisine de 8$\mu$m. Dans ces conditions, et selon la relation (2), la réflectance à l'interface entre la couche sélective selon l'invention et le support bon réflecteur des infrarouges est plus importante ($\rho$=94% en considérant un support en aluminium) qu'à l'interface entre une couche de VO$_2$ pur et le même support ($\rho$=91%). Ainsi le matériau multicouche selon l'invention présente également une émissivité infrarouge à basse température (~6%) plus faible qu'un matériau à base de VO$_2$ pur (~9%), ce qui confère un meilleur rendement à basse température au panneau solaire thermique utilisant un matériau multicouche selon l'invention.

3) Réalisation et propriétés de la couche sélective selon l'invention

Parmi les matériaux multicouches selon l'invention comprenant une couche sélective constituée d'une combinaison d'oxydes de Vanadium de la forme VO$_2$/$V_nO_{2n\pm1}$, avec n > 1, les combinaisons d'oxydes de la forme VO$_2$/$V_4O_9$ et VO$_2$/$V_6O_{13}$ ont donné les meilleurs résultats.

La proportion de phase $V_nO_{2n\pm1}$ dans la combinaison d'oxydes VO$_2$/$V_nO_{2n\pm1}$ permet notamment de moduler la valeur du coefficient d'extinction k2 et la valeur de la transmittance infrarouge Tr de la couche sélective à T > Tc : plus cette proportion est importante plus la réduction de k2 (par rapport au coefficient d'extinction d'une couche de VO$_2$ pur de même épaisseur) à T > Tc est importante.

Une couche biphasée de VO$_2$ et de $V_nO_{2n\pm1}$.peut être élaborée par pulvérisation cathodique magnétron en condition réactive à partir d'une cible métallique de vanadium, avec ou sans recuit ex-situ de cristallisation, ou par un procédé d'oxydation de revêtements minces de vanadium, ou par un procédé de type sol-gel, ou par tout autre procédé permettant la formation d'un revêtement d'oxyde de vanadium au minimum biphasé, cristallisé, et de composition contrôlée. Dans le cas de la pulvérisation cathodique magnétron en condition réactive, la formation d'une couche VO$_2$/$V_nO_{2n\pm1}$ dépend essentiellement du contrôle précis de la pression partielle d'oxygène dans le réacteur, via le débit d'oxygène (DO$_2$) introduit, les autres paramètres de dépôt étant constants ; le procédé nécessite généralement la mise en oeuvre d'un système optique de régulation du procédé en boucle fermée (Optical Emission Spectroscopy).

Par exemple, deux couches sélectives VO$_2$/$V_4O_9$ selon l'invention, présentant deux proportions différentes de phase $V_4O_9$, peuvent être synthétisées avec les paramètres de dépôt présentés dans le tableau II ci-dessous. Les conditions d'élaboration d'une couche de $VO_2$ pur dans le même réacteur sont rappelées pour comparaison.

*Tableau II. Paramètres de dépôt principaux pour la formation par pulvérisation cathodique magnétron en condition réactive d'une couche de $VO_2$ pur et de deux couches sélectives $VO_2/V_4O_9$ selon l'invention.*

|  | $VO_2$ pur | $VO_2/V_4O_9$ #1 | $VO_2/V_4O_9$ #2 |
|---|---|---|---|
| $DO_2/(DO_2+D_{Ar})$ | 0,09 | 0,0909 | 0,092 |
| P (W) | 330 | 330 | 330 |
| Pr (Pa) | 1,2 | 1,2 | 1,2 |

Avec : $DO_2$ débit d'oxygène introduit dans le réacteur
$D_{Ar}$ débit d'argon introduit dans le réacteur
P puissance dissipée sur la cible de vanadium pur
Pr pression totale dans le réacteur

Dans le cas d'un procédé d'oxydation sous atmosphère contrôlée d'une couche mince de vanadium, l'obtention d'une couche biphasée $VO_2/V_nO_{2n\pm1}$ dépend principalement de l'épaisseur initiale de la couche de vanadium, de la pression partielle d'oxygène présente dans le réacteur, de la durée, et de la température du procédé d'oxydation. Il a également été montré expérimentalement que la densité initiale et les contraintes internes de la couche de vanadium étaient un paramètre influant sur les cinétiques d'oxydation.

La couche sélective selon l'invention présente de préférence une épaisseur minimum de 100nm afin de garantir une absorbance de 75% au minimum pour des rayonnements dont la longueur d'onde est comprise entre 0,4 et 2,5$\mu$m. La couche sélective selon l'invention présente de préférence une épaisseur maximum de 500 nm, pour ne pas entrainer une émissivité infrarouge pour des longueurs d'onde entre 7 et 8$\mu$m supérieure à 15% à T < Tc. En effet même si le coefficient d'extinction k2 de la couche sélective selon l'invention est très proche de zéro pour T < Tc, il n'est pas nul, et le rayonnement infrarouge incident est d'autant plus absorbé et l'émissivité infrarouge est d'autant plus augmentée que l'épaisseur de la couche sélective est importante (du fait de l'augmentation du trajet du rayonnement dans la couche). Ainsi, la couche absorbante a de préférence une épaisseur comprise entre 100 et 500 nm.

L'épaisseur de la couche sélective peut être ajustée afin d'augmenter l'effet antireflet de la couche sélective sur le support bon réflecteur des infrarouges.

4) Variantes, améliorations

La couche sélective selon l'invention peut être dopée avec au moins un métal M différent du Vanadium, M étant par exemple de l'aluminium, du chrome ou du titane. Ainsi, certains atomes de vanadium des oxydes de vanadium formés ($VO_2/V_nO_{2n\pm1}$) sont substitués par des atomes du métal M de dopage. Par le choix du métal M et de sa concentration, il devient possible d'ajuster la température critique Tc du matériau à une valeur souhaitée ; par exemple, une couche sélective dopée à l'aluminium a une température critique comprise entre 80 et 120°C.

Un dopage avec plusieurs métaux M1, M2, ... peut également être envisagé, éventuellement avec des concentrations différentes pour chaque métal. Ceci permet notamment un ajustement plus fin de la température critique à une valeur souhaitée.

Un tel dopage peut être réalisé lors de l'élaboration d'une couche sélective $VO_2/V_nO_{2n\pm1}$ selon l'invention sur un support en aluminium à l'aide d'un procédé d'oxydation d'une couche de vanadium $VO_2$ pur en présence d'une certaine proportion d'oxygène : pour réaliser ce dopage, la température de traitement peut être adaptée afin de favoriser la diffusion à l'état solide d'atomes d'aluminium du support dans la couche $VO_2/V_nO_{2n\pm1}$ en cours d'oxydation phénomène d'auto-dopage). L'expérience montre qu'un tel procédé d'oxydation réalisé à 550°C permet d'augmenter la température critique Tc de la couche sélective $VO_2/V_nO_{2n\pm1}$ au-delà de 80°C avec une variation de l'émissivité infrarouge en fonction de la température supérieure à 25%.

Un matériau selon l'invention avec une température critique supérieure à 80°C permet, en plus de la réduction de la température de stagnation d'au moins 30°C, de réaliser un panneau solaire ayant un meilleur rendement à basse température (T < Tc) qu'un panneau solaire utilisant une couche sélective de $VO_2$ pur. En effet, plus la température critique est proche de la température moyenne de fonctionnement d'un absorbeur traditionnel (100-120°C), plus le rendement d'un panneau solaire utilisant un matériau selon l'invention sera élevé, compte tenu de l'utilisation d'un maximum de l'énergie solaire avant la transformation de la couche sélective selon l'invention.

Selon une variante, la couche sélective selon l'invention présente une concentration en dopant M suffisante pour former au moins un oxyde de la forme $M_{1-x}O_x$, avec $0 < x < 1$, x étant la fraction atomique de l'oxygène dans l'oxyde, de sorte que la couche sélective comprend une combinaison d'oxydes de type $VO_2$, $V_nO_{2n\pm1}$ et $M_{1-x}O_x$. En

effet, lorsque la concentration en dopant M est suffisante, supérieure à une concentration critique en dopant, le mécanisme de substitution des atomes de vanadium des oxydes de vanadium formés ($VO_2/V_nO_{2n\pm1}$) est remplacé par la formation d'un oxyde du métal M utilisé pour le dopage. Dans ces conditions, la couche sélective selon l'invention comprend une combinaison d'oxydes de type $VO_2$, $V_nO_{2n\pm1}$ et de la forme $M_{1-x}O_x$, M étant le métal utilisé pour le dopage. Comme précédemment, un dopage avec plusieurs métaux M1, M2, ... peut être envisagé pour obtenir au moins un oxyde d'au moins un des métaux M1, M2, ... ; également, une combinaison de plusieurs oxydes de métal M peut être envisagée, en complément des oxydes $VO_2$ et $V_nO_{2n\pm1}$.

De préférence, le métal M (ou les métaux M1, M2, ...) est choisi de sorte que le ou les oxydes de la forme $M_{1-x}O_x$ obtenus présentent une transmittance supérieure à 85% pour les rayonnements infrarouges dont la longueur d'onde est comprise entre 6 et 10$\mu$m. Ainsi, en complément de l'augmentation de la température critique Tc, la formation d'un troisième oxyde $M_{1-x}O_x$ permet d'augmenter la transmittance infrarouge partielle de la couche sélective à T > Tc et d'augmenter la variation d'émissivité infrarouge en fonction de la température.

La concentration critique en dopant, limite entre processus de substitution d'atome et processus d'oxydation, est fonction notamment du métal M, mais également du procédé de fabrication du matériau. Par exemple, l'expérience montre que, avec le procédé de fabrication testé et l'utilisation d'aluminium comme dopant, la concentration critique est de 5% atomique d'aluminium pour permettre la formation d'un oxyde d'aluminium.

De préférence, le métal M choisi est de l'aluminium et l'oxyde de la forme $M_{1-x}O_x$ obtenu est un oxyde d'aluminium, $Al_2O_3$ par exemple (avec x = 0,6), ou un oxyde d'aluminium sous-stoechiométrique. Parmi les essais réalisés, le choix d'une concentration de dix pourcent atomique d'aluminium (10 at.% Al) permet la formation d'une couche de la forme $VO_2/V_nO_{2n\pm1}/Al_2O_3$ avec une température critique Tc supérieure à 80°C, et une émissivité infrarouge supérieure à 40% à 150°C. Par ailleurs, l'expérience montre que la présence du nouvel oxyde $Al_2O_3$ permet d'augmenter l'absorption solaire de la couche sélective. Une mesure de réflectance entre 0,4 et 2,5$\mu$m montre une absorption solaire de l'ordre de 83% pour une couche sélective obtenue avec l'aluminium choisi comme dopant, alors que les couches sélectives obtenues sans dopage sont caractérisés par une absorption solaire de 78 à 79% au maximum.

Dans ces conditions un panneau solaire thermique dont l'absorbeur est réalisé avec un matériau multicouche comprenant une couche sélective $VO_2/VnO_{2n\pm1}/Al_2O_3$ est plus efficace à basse température compte tenu d'un coefficient d'absorption solaire plus élevé, et permet de réduire la température de stagnation d'au moins 40°C par rapport à un panneau solaire thermique classique (Modèle VITOSOL 200F Viessmann pris comme référence). La température de stagnation est ainsi toujours inférieure à 160°C et permet de toujours garantir l'intégrité du fluide caloporteur.

<u>5) Autres variantes, améliorations</u>

Le matériau multicouche selon l'invention peut également comprendre, entre la couche sélective et le support, une couche adhésive, par exemple une couche métallique, une couche d'oxydes, une couche de nitrures de métaux de transition ou une couche d'un mélange de ces matériaux, d'une épaisseur comprise entre 5 et 100 nm. La couche adhésive améliore l'adhérence de la couche sélective sur le support.

Dans le matériau multicouche selon l'invention, la couche sélective peut également être recouverte d'une couche antireflet ayant un indice optique n3 < n2, n2 tant l'indice optique que la couche sélective, pour des rayonnements dont la longueur d'onde est comprise entre 0,4 et 2,5$\mu$m. L'effet antireflet ainsi créé permet d'augmenter l'absorbance globale du matériau multicouche de 75-80% (= absorbance de la couche sélective) à 90% au moins. La couche antireflet a une épaisseur comprise entre 10 et 150 nm. Une couche d'épaisseur supérieure à 150 nm entraînerait une dégradation non souhaitée des propriétés du matériau dans le domaine infrarouge.

Egalement, dans le matériau multicouche selon l'invention, le support réflecteur des infrarouges (longueurs d'onde entre 6 et 10$\mu$m) peut être :

- un support constitué d'une unique couche d'un matériau réflecteur ayant une réflectance R supérieure à 80% pour des rayonnements de longueur d'onde supérieure à 5$\mu$m, une couche d'aluminium par exemple, ou bien
- un support comprenant une couche support mécanique réalisée en un matériau faiblement réflecteur des infrarouges recouverte d'une couche opaque présentant une réflectance supérieure à 80% pour des rayonnements de longueur d'onde supérieure à 5$\mu$m.

L'invention concerne également un panneau solaire comprenant un matériau multicouche tel que celui décrit ci-dessus.

Bien sûr, tous les perfectionnements et variantes décrits aux points 2, 4 et 5 peuvent être envisagés seuls ou en combinaison. Egalement, le point 3 décrit un exemple de procédé de réalisation d'une couche sélective selon l'invention, mais d'autres procédés d'oxydation connus peuvent être envisagés pour la réalisation de la couche sélective.

**Brève description des figures**

L'invention sera mieux comprise, et d'autres caractéristiques et avantages de l'invention apparaîtront à la lumière de la description qui suit d'exemples de matériau selon l'invention. Ces exemples sont donnés à titre non limitatif. La description est à lire en relation avec les dessins annexés dans lesquels :

- la figure 1 détaille la constitution d'un matériau multicouche comprenant une couche sélective à base de $VO_2$ pur,
- les figures 2-4 montrent la constitution de matériaux multicouches selon l'invention,
- la figure 5 montre un cliché de diffraction des rayons X de la couche 32,
- la figure 6 montre des résultats de mesures réalisées sur le matériau de la figure 3, et
- la figure 7 montre des résultats de mesures réalisées sur le matériau de la figure 4.

**Description d'un mode de réalisation de l'invention**

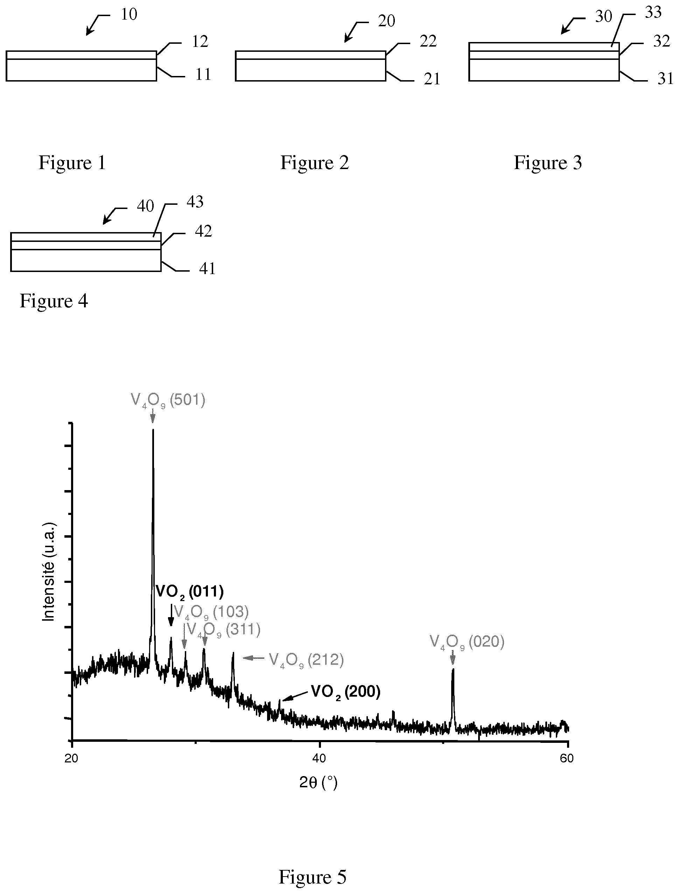

La figure 1 montre un matériau 10 comprenant un support 11 recouvert d'une couche 12 d'oxyde de Vanadium $VO_2$ pur. La couche 12 a des propriétés thermochromes et notamment une transmittance dans l'infrarouge (longueurs d'ondes comprises entre 6 à 10 $\mu$m) Tr inférieure à 10% à T > Tc. La couche 12 est ainsi quasiment opaque au rayonnement infrarouge à haute température. La couche 12 a une épaisseur de l'ordre de 100 à 500 nm.

Un exemple de matériau 20 selon l'invention est représenté sur la figure 2. Il comprend un support 21 et une couche 22 de matériau biphasé comprenant des oxydes de Vanadium de type $VO_2$ et $V_4O_9$, éventuellement dopé avec une concentration en dopant inférieure à la concentration critique. La couche 22 a une épaisseur de l'ordre de 100 à 500 nm.

Les supports 11, 21 sont réalisés en un matériau opaque et réflecteur des infrarouges (réflectance R supérieure à 80% pour des rayonnements de longueur d'onde est supérieure à 5 $\mu$m), et mécaniquement suffisamment résistant pour pouvoir réaliser une plaque rigide de grande dimension (1 à 3 $m^2$ de surface). Ils sont par exemple réalisés en aluminium (réflectance R > 90%), ou bien en un matériau présentant une résistance mécanique suffisante, recouvert d'une couche d'aluminium opaque. L'indice optique n1 et le coefficient d'extinction k1 du support sont respectivement de l'ordre de 5 à 25 et de 30 à 86 pour des longueurs d'onde comprises entre 6 et 10 $\mu$m.

La couche 12 ($VO_2$) a les propriétés suivantes :

- absorbance solaire de l'ordre de 75-80%

- transmittance infrarouge Tr (longueurs d'ondes comprises entre 6 et 10$\mu$m) :

    ➢ de l'ordre de 90% lorsque la température T est inférieure à Tc de l'ordre de 65 à 120°C
    ➢ de l'ordre de 5 % lorsque la température T est supérieure à Tc

La couche 22 ($VO_2$ + $V_4O_9$) a les propriétés suivantes :

- absorbance solaire de l'ordre de 75-80%

- transmittance infrarouge Tr (longueurs d'ondes comprises entre 6 et 10 $\mu$m) :

    ➢ de l'ordre de 90% lorsque la température T est inférieure à Tc de l'ordre de 65 à 120°C
    ➢ de l'ordre de 25 à 35% lorsque la température T est supérieure à Tc

- un indice optique n2 inférieur à l'indice optique n1 du support 21, soit de l'ordre de 4 à 6 pour des longueurs d'ondes comprises entre 6 et 10$\mu$m.

Pour les basses températures (T < Tc), la couche 12 est quasi transparente au rayonnement infrarouge (transmittance de l'ordre de 90%) ; ainsi l'émissivité du matériau 10 dépend essentiellement de l'émissivité du support 11 ; le support 11 étant réflecteur des infrarouges, son émissivité infrarouge est très faible de sorte que l'émissivité infrarouge du matériau 10 est très faible ; le matériau 10 a donc de très faibles pertes thermiques pour des températures inférieures à Tc. Le matériau 10 a par ailleurs une absorbance égale à celle de la couche 12, de l'ordre de 75 à 80%, donc un rendement de conversion de l'énergie solaire élevé. Le matériau 20 a le même comportement que le matériau 10 pour T < Tc.

Pour les températures élevées (T > Tc), la couche 12 est quasi opaque au rayonnement infrarouge (transmittance inférieure à 10%) ; ainsi l'émissivité du matériau 10 dépend essentiellement de l'émissivité de la couche 12, de l'ordre de 25 à 30%. La température de stagnation la plus faible du matériau 10 est d'environ 180°C.

Par contre, pour les températures élevées (T > Tc), la couche 22 est partiellement transparente au rayonnement infrarouge (transmittance de l'ordre de 30%) ; la réflectance infrarouge du matériau 20 est donc plus faible que celle du matériau 10 et son émissivité infrarouge est plus importante que celle du matériau 10 ; par ailleurs l'augmentation du trajet des rayonnements infrarouges dans la couche 22 permet d'augmenter d'avantage l'émissivité infrarouge à T > Tc. Finalement, n2 étant inférieure à n1, la couche 22 peut jouer un rôle antireflet sur le support 21 et réduire d'avantage la réflexion optique du matériau multicouche 20. Dans ces conditions, l'émissivité du matériau 20 est supérieure à 35%, et de préférence supérieure à 40%. Le matériau 20 s'échauffe donc beaucoup moins que le matériau 10. Des essais montrent que la température de stagnation du matériau 20 est en pratique de l'ordre de 140 à 160°C, et dans tous les cas inférieure à 170°C.

La figure 3 est un autre exemple d'un matériau 30 selon l'invention. Le matériau 30 comprend un support 31 sur lequel est déposée une couche sélective 32 comprenant une combinaison d'oxydes $VO_2$ et $V_4O_9$, éventuellement dopé avec une concentration en dopant inférieure à la concentration critique. La figure 5 met en évidence par diffraction des rayons X les phases $VO_2$ et $V_4O_9$ avec une proportion importante de phase $V_4O_9$. La couche 32 présente ainsi une transmittance partielle comprise entre 25 et 30% pour des longueurs d'ondes comprises entre 6 et 10$\mu$m. Le matériau 30 comprend en complément une couche 33 antireflet réalisée dans un matériau tel que de l'oxyde de silicium $SiO_2$ caractérisé par un indice optique n3 proche de 1,5 pour des longueurs d'ondes comprises entre 0,3 et 2,5$\mu$m. La couche antireflet 33 permet d'améliorer l'absorbance du matériau 30, qui atteint ainsi plus de 90%. L'épaisseur de la couche 33 est ajustée pour maximiser l'effet antireflet dans le domaine visible qui correspond approximativement au maximum d'émission solaire ; pour cela, l'épaisseur de la couche 33 est choisie proche du quart de la longueur d'onde du rayonnement visible divisée par n3 soit une épaisseur de l'ordre de 60 nm (380nm/4/1,5 = 63nm), à 130 nm (780nm/4/1,5 = 130nm), pour un rayonnement visible de longueur d'onde comprise entre 380 nm et 780 nm.

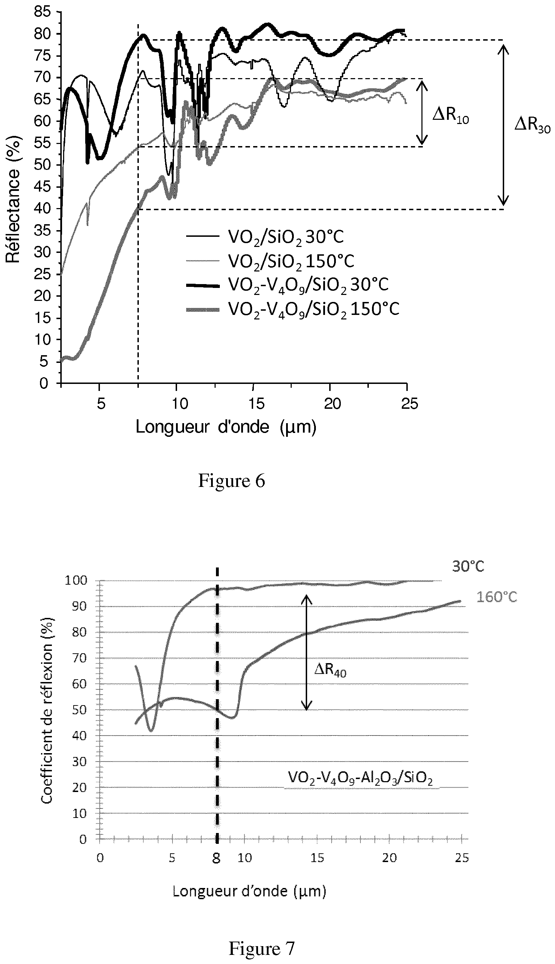

La figure 6 montre la variation de réflectance $\Delta R$ (réflectance à T > Tc moins réflectance à T < Tc), et donc d'émissivité, en fonction de la longueur d'onde pour :

- le matériau 30 : Support Aluminium / couche absorbante $VO_2$ + V4O9 / couche Si02
- le matériau 10 avec une couche antireflet de même nature et de même épaisseur que celle déposée sur le matériau 30 : Support Aluminium / couche absorbante $VO_2$ / couche Si02

On voit que dans le cas du matériau 30, la variation d'émissivité $\Delta R_{30}$ est plus importante que la variation d'émissivité $\Delta R_{10}$ du matériau 10. Cette variation importante entraîne une baisse significative de la température de stagnation. Par ailleurs, et comme expliqué dans le descriptif de l'invention, le matériau multicouche selon l'invention présente également une réflectance infrarouge à T < Tc plus importante qu'un matériau multicouche dont la couche sélective est constituée de $VO_2$ pur. Dans ces conditions le rendement à T < Tc d'un panneau solaire équipé du matériau multicouche selon l'invention est augmenté.

La figure 4 est un autre exemple d'un matériau 40 selon l'invention. Le matériau 40 comprend un support 41 sur lequel est déposée une couche sélective 42 comprenant une combinaison d'oxydes $VO_2$, $V_4O_9$ et $Al_2O_3$, (obtenue par un dopage avec une concentration en aluminium de 10% atomique, soit supérieure à la concentration critique), recouverte d'une couche antireflet 43. Le matériau 40 présente une absorption solaire entre 0,4 et 2,5$\mu$m supérieure à 94% ainsi qu'une émissivité infrarouge mesurée à 8$\mu$m variant entre 5 et 45% en fonction de la température.

La figure 7 montre la variation de réflectance $\Delta R$ (réflectance à T > Tc moins réflectance à T < Tc), et donc d'émissivité, en fonction de la longueur d'onde pour le matériau 40, et met en évidence une variation d'émissivité $\Delta R_{40}$ encore améliorée par rapport au matériau 30. En effet alors que $\Delta R_{30}$ est de l'ordre de 38%, $\Delta R_{40}$ atteint environ 46% pour une longueur d'onde de 8$\mu$m. La figure 7 met également en évidence un meilleur comportement du matériau 40 à basse température avec un coefficient de réflexion à 8$\mu$m de l'ordre de 96% (i.e. émissivité voisine de 4%).

Dans ces conditions, un capteur solaire thermique équipé du matériau 40 selon l'invention présente à T < Tc, avec Tc > 80°C, un fonctionnement identique à celui d'un capteur solaire thermique standard, avec une absorption solaire de 94% et une émissivité infrarouge de 5%, et permet en outre, à T > Tc, de réduire considérablement la température de stagnation à une valeur inférieure à 160°C.

## Revendications

1. Matériau multicouche comprenant au moins:

   • un support ayant une réflectance R supérieure à 80% pour des rayonnements de longueur d'onde supérieure à 5$\mu$m,
   • une couche sélective d'épaisseur comprise entre 100 et 500 nm comprenant une combinaison de V02 et VnO2n+/-1, avec n > 1, la dite couche sélective présentant une absorbance supérieure à 75% pour des rayonnements de longueur d'onde comprise entre 0,4 et 2,5 $\mu$m quelle que soit la température T et ayant, pour des rayonnements de longueur d'onde comprise entre 6 et 10 $\mu$m, une transmittance Tr telle que :

➢ Tr > 85 % pour T < Tc, une température critique,
➢ 20% $\leq$ Tr $\leq$ 50% pour T > Tc.

**2.** Matériau selon la revendication 1 dans lequel la couche sélective présente un coefficient d'extinction k inférieur à 4 pour des rayonnements de longueur d'onde comprise entre 6 et 10$\mu$m.

**3.** Matériau selon l'une des revendications 1 à 2 dans lequel, pour des rayonnements de longueur d'onde comprise entre 6 et 10 $\mu$m, le support a un indice optique n1 et la couche sélective a un indice optique n2 tel que :

• n2 < n1 quelle que soit la température T, et
• n2 < 6 pour T > Tc.

**4.** Matériau selon la revendication 3 dans lequel, pour des rayonnements de longueur d'onde comprise entre 6 et 10 $\mu$m l'indice optique n2 est compris entre $0,8*(n1)^{1/2}$ et $1,2*(n1)^{1/2}$ pour T > Tc.

**5.** Matériau selon l'une des revendications 1 à 4 dans lequel la couche sélective est dopée avec au moins un métal M différent du Vanadium, M étant par exemple de l'aluminium, du chrome ou du titane.

**6.** Matériau selon la revendication 5 dans lequel la couche sélective est dopée avec de l'aluminium et présente une température critique comprise entre 80°C et 120°C.

**7.** Matériau selon l'une des revendications 5 ou 6 dans lequel la couche sélective présente une concentration en dopant M suffisante pour former au moins un oxyde de la forme $M_{1-x}O_x$, avec 0 < x < 1, x étant la fraction atomique de l'oxygène dans l'oxyde, de sorte que la couche sélective comprend une combinaison d'oxydes de type $VO_2$, $V_nO_{2n+/-1}$ et $M_{1-x}O_x$.

**8.** Matériau selon la revendication 7 dans lequel l'oxyde de la forme $M_{1-x}O_x$ est un oxyde d'aluminium, $Al_2O_3$ par exemple, ou un oxyde d'aluminium sous-stœchiométrique.

**9.** Matériau selon l'une des revendications 1 à 8 dans lequel la couche sélective est recouverte d'une couche antireflet ayant, pour des rayonnements dont la longueur d'onde est comprise entre 0,4 et 2,5$\mu$m, un indice optique n3 < n2, n2 étant l'indice optique de la couche sélective.

**10.** Matériau selon la revendication 9 dans lequel la couche antireflet présente une épaisseur comprise entre 10 et 150nm.

**11.** Matériau selon l'une des revendications 1 à 10 comprenant également, entre la couche sélective et le support, une couche adhésive, par exemple une couche métallique, une couche d'oxydes, une couche de nitrures de métaux de transition ou une couche d'un mélange de ces matériaux, d'une épaisseur comprise entre 5 et 100 nm.

**12.** Matériau selon l'une des revendications précédentes, dans lequel la couche sélective comprend :

• une combinaison d'oxydes de Vanadium V02 et V4O9, ou
• une combinaison d'oxydes de Vanadium V02 et V6O13, ou
• une combinaison d'oxydes de Vanadium V02 et V4O9 et de l'oxyde Al2O3

**13.** Panneau solaire comprenant un matériau multicouche selon l'une des revendications précédentes.


**Patentansprüche**

**1.** Mehrschichtiges Material, das mindestens umfasst:

• einen Träger mit einer Reflektanz R über 80 % für Strahlungen mit einer Wellenlänge über 5 $\mu$m,
• eine selektive Schicht mit einer Stärke zwischen 100 und 500 nm inklusive, umfassend eine Kombination aus VO2 und VnO2n+/-1 mit n > 1, wobei die selektive Schicht eine Absorbanz über 75 % für Strahlungen der Wellenlänge zwischen 0,4 und 2,5 μm inklusive unabhängig von der Temperatur T aufweist und für Strahlungen der Wellenlänge zwischen 6 und 10 μm inklusive eine Transmittanz Tr hat, die derart ist, dass:

> ➢ Tr > 85 % für T < Tc, eine kritische Temperatur,
> ➢ 20 % ≤ Tr ≤ 50 % für T > Tc.

2. Material nach Anspruch 1, wobei die selektive Schicht einen Extinktionskoeffizienten k kleiner als 4 für Strahlungen der Wellenlänge zwischen 6 und 10 μm inklusive aufweist.

3. Material nach einem der Ansprüche 1 bis 2, wobei für Strahlungen der Wellenlänge zwischen 6 und 10 μm inklusive der Träger einen optischen Index n1 hat und die selektive Schicht einen optischen Index n2 hat, so dass:

- n2 < n1 unabhängig von der Temperatur T, und
- n2 < 6 für T > Tc.

4. Material nach Anspruch 3, wobei für Strahlungen der Wellenlänge zwischen 6 und 10 μm inklusive der optische Index n2 zwischen 0,8*(n1)1/2 und 1,2*(n1)1/2 inklusive für T > Tc ist.

5. Material nach einem der Ansprüche 1 bis 4, wobei die selektive Schicht mit mindestens einem Metall M dotiert ist, das sich von Vanadium unterscheidet, wobei M beispielsweise Aluminium, Chrom oder Titan ist.

6. Material nach Anspruch 5, wobei die selektive Schicht mit Aluminium dotiert ist und eine kritische Temperatur zwischen 80 °C und 120 °C inklusive aufweist.

7. Material nach einem der Ansprüche 5 oder 6, wobei die selektive Schicht eine Konzentration an Dotiermittel M aufweist, die ausreichend ist, um mindestens ein Oxid der Form M1-xOx mit 0 < x < 1 zu bilden, wobei x die Atomfraktion des Sauerstoffs in dem Oxid ist, so das die selektive Schicht eine Kombination von Oxiden vom Typ VO2, VnO2n+/-1 und M1-xOx umfasst.

8. Material nach Anspruch 7, wobei das Oxid der Form M1-xOx ein Aluminiumoxid, beispielsweise Al2O3, oder ein substöchiometrisches Aluminiumoxid ist.

9. Material nach einem der Ansprüche 1 bis 8, wobei die selektive Schicht mit einer Antireflexschicht bedeckt ist, die für Strahlungen, deren Wellenlänge zwischen 0,4 und 2,5 μm inklusive ist, einen optischen Index n3 < n2 hat, wobei n2 der optische Index der selektiven Schicht ist.

10. Material nach Anspruch 9, wobei die Antireflexschicht eine Stärke zwischen 10 und 150 nm inklusive aufweist.

11. Material nach einem der Ansprüche 1 bis 10, umfassend ebenfalls zwischen der selektiven Schicht und dem Träger eine Haftschicht, beispielsweise eine Metallschicht, eine Oxidschicht, eine Nitridschicht von Übergangsmetallen oder eine Schicht aus einem Gemisch dieser Materialien mit einer Stärke zwischen 5 und 100 nm inklusive.

12. Material nach einem der vorangehenden Ansprüche, wobei die selektive Schicht umfasst:

- eine Kombination von Vanadiumoxiden VO2 und V4O9, oder
- eine Kombination von Vanadiumoxiden VO2 und V6O13, oder
- eine Kombination von Vanadiumoxiden VO2 und V4O9 und des Oxids Al2O3.

13. Solarpanel, umfassend ein mehrschichtiges Material nach einem der vorangehenden Ansprüche.

**Claims**

1. A multilayer material comprising at least:

- a support having a reflectance R greater than 80% for radiations of a wavelength greater than 5μm,
- a selective layer with a thickness comprised between 100 and 500 nm comprising a combination of $VO_2$ and

$VnO_{2n}$+/-1, with n > 1, said selective layer having an absorbance greater than 75% for radiations of wavelength comprised between 0.4 and 2.5 $\mu$m regardless of the temperature T and having for radiations of a wavelength comprised between 6 and 10 $\mu$m, a transmittance Tr such that:

    ➢ Tr > 85 % for T < Tc, a critical temperature,
    ➢ 20% $\leq$ Tr $\leq$ 50% for T > Tc.

2. The material according to claim 1 wherein the selective layer has an extinction coefficient k of less than 4 for radiations with a wavelength comprised between 6 and 10 $\mu$m.

3. The material according to one of claims 1 to 2 wherein, for radiations of wavelength comprised between 6 and 10 $\mu$m, the support has a refractive index n1 and the selective layer has a refractive index n2 such that:

    • n2 < n1 regardless of the temperature T, and
    • n2 < 6 for T > Tc.

4. The material according to claim 3 wherein, for radiations of a wavelength comprised between 6 and 10 $\mu$m, the refractive index n2 is comprised between $0.8*(n1)^{1/2}$ and $1.2*(n1)^{1/2}$ for T > Tc.

5. The material according to one of claims 1 to 4, wherein the selective layer is doped with at least one metal M different from Vanadium, M being for example aluminium, chromium or titanium.

6. The material according to claim 5, wherein the selective layer is doped with aluminium and has a critical temperature comprised between 80°C and 120°C.

7. The material according to one of claims 5 or 6, wherein the selective layer has a concentration of dopant M sufficient for forming at least one oxide of the form $M_{1-x}O_x$, with 0 < x < 1, x being the atomic fraction of oxygen in the oxide, so that the selective layer comprises a combination of oxides of the $VO_2$ type, $V_nO_{2n+/-1}$ and $M_{1-x}O_x$.

8. The material according to claim 7 wherein the oxide of the form M1-xOx is an aluminium oxide, $Al_2O_3$ for example, or a sub-stoichiometric aluminium oxide.

9. The material according to one of claims 1 to 8, wherein the selective layer is covered with an anti-reflective layer having, for radiations for which the wavelength is comprised between 0.4 and 2.5 $\mu$m, a refractive index n3 < n2, n2 being the refractive index of the selective layer.

10. The material according to claim 9 wherein the anti-reflective layer has a thickness comprised between 10 and 150 nm.

11. The material according to one of claims 1 to 10, also comprising, between the selective layer and the support an adhesive layer, for example a metal layer, a layer of oxides, a layer of transition metal nitrides or a layer of a mixture of these materials, with a thickness comprised between 5 and 100 nm.

12. The material according to one of the preceding claims, wherein the selective layer comprises:

    • a combination of vanadium oxides VO2 and V4O9, or
    • a combination of vanadium oxides VO2 and V6O13, or
    • a combination of vanadium oxides VO2 and V9O9 and of the Al2O3 oxide.

13. A solar panel comprising a multilayer material according to one of the preceding claims.

Figure 1

Figure 2

Figure 3

Figure 4

Figure 5

Figure 6

Figure 7

**RÉFÉRENCES CITÉES DANS LA DESCRIPTION**

**Documents brevets cités dans la description**

- WO 2012069718 A

- US 7691435 B2

**Littérature non-brevet citée dans la description**

- **F. GUINNETON et al.** *Thin Solid Films,* 2004, vol. 446, 287-295